# EUROPÄISCHE PATENTSCHRIFT

(11) **EP 3 268 212 B1**
(45) Veröffentlichungstag und Bekanntmachung des Hinweises auf die Patenterteilung: **19.01.2022**
(21) Anmeldenummer: 16709744.3
(22) Anmeldetag: 09.03.2016
(51) Int. Cl.: B29C 67/00, B33Y 10/00, B33Y 30/00, B33Y 40/00, G03F 7/00, G03F 7/20

(54) **VERFAHREN UND SYSTEM UMFASSEND EINE STRAHLUNGSQUELLE UND EINE VORRICHTUNG ZUR KORREKTUR EINER INHOMOGENEN INTENSITÄTSVERTEILUNG EINES VON DER STRAHLUNGSQUELLE ERZEUGTEN STRAHLUNGSFELDES**
METHOD AND SYSTEM COMPRISING A RADIATION SOURCE AND AN APPARATUS FOR CORRECTING AN INHOMOGENEOUS INTENSITY DISTRIBUTION OF A RADIATION FIELD GENERATED BY THE RADIATION SOURCE
PROCÉDÉ ET SYSTÈME COMPRENANT UNE SOURCE DE RAYONNEMENT ET UN DISPOSITIF DE CORRECTION D'UNE DISTRIBUTION D'INTENSITÉ NON-HOMOGÈNE D'UN CHAMP DE RAYONNEMENT GÉNÉRÉ PAR LA SOURCE DE RAYONNEMENT

(30) Priorität: 09.03.2015 DE 102015103389
(43) Veröffentlichungstag der Anmeldung: 17.01.2018
(73) Patentinhaber: Schultheiss GmbH, 71296 Heimsheim (DE)
(72) Erfinder: SCHULTHEISS, Andreas, 75417 Mühlacker (DE)
(74) Vertreter: Hoeger, Stellrecht & Partner Patentanwälte mbB
(86) Internationale Anmeldenummer: PCT/EP2016/054961
(87) Internationale Veröffentlichungsnummer: WO 2016/142398

(56) Entgegenhaltungen:
- DE-A1-102013 107 571
- DE-U1- 9 319 405
- US-A1- 2008 038 396

## Beschreibung

Die vorliegende Erfindung betrifft ein System umfassend eine Strahlungsquelle und eine Vorrichtung zur Korrektur einer inhomogenen Intensitätsverteilung eines von der Strahlungsquelle erzeugten Strahlungsfeldes für eine Vorrichtung zum Herstellen dreidimensionaler Objekte durch schichtweises Verfestigen eines unter Einwirkung von Strahlung verfestigbaren Materials in einer Bauebene erzeugten Strahlungsfeldes, wobei die Vorrichtung eine Korrektur- oder Filtereinrichtung zum Einbringen in einen Strahlengang einer Vorrichtung zum Herstellen dreidimensionaler Objekte durch schichtweises Verfestigen eines unter Einwirkung von Strahlung verfestigbaren Materials zwischen der Strahlungsquelle und der Bauebene umfasst, wobei eine Intensitätsverteilung des Strahlungsfeldes in einer Kalibrierfläche zwischen der Strahlungsquelle und der Bauebene oder in der Bauebene gemessen oder berechnet und eine Korrektur- oder Filtereinrichtung zum Einbringen in den Strahlengang ausgebildet ist in Abhängigkeit der Intensitätsverteilung des Strahlungsfeldes in der Kalibrierfläche derart, dass die Intensitätsverteilung des Strahlungsfeldes in der Bauebene nach dem Passieren der Korrektur- oder Filtereinrichtung homogen ist, wobei ein Absorptions- oder Reflexionsverhalten der Korrektur- oder Filtereinrichtung zeitlich konstant ist, wobei die Korrektur- oder Filtereinrichtung einen Träger und mindestens eine auf dem Träger ausgebildete oder aufgebrachte Korrektur- oder Filterschicht umfasst und wobei die Korrektur- oder Filterschicht ausgebildet ist in Abhängigkeit der Intensitätsverteilung des Strahlungsfeldes in der Kalibrierfläche derart, dass die Intensitätsverteilung des Strahlungsfeldes in der Bauebene nach dem Passieren der Korrektur- oder Filtereinrichtung homogen ist.

Ferner betrifft die vorliegende Erfindung ein Verfahren zum Herstellen einer Vorrichtung zur Korrektur einer inhomogenen Intensitätsverteilung eines von einer Strahlungsquelle erzeugten Strahlungsfeldes einer Vorrichtung zum Herstellen dreidimensionaler Objekte durch schichtweises Verfestigen eines unter Einwirkung von Strahlung verfestigbaren Materials in einer Bauebene, wobei eine Intensitätsverteilung des Strahlungsfeldes in einer Kalibrierfläche zwischen der Strahlungsquelle und der Bauebene oder in der Bauebene gemessen oder berechnet und eine Korrektur- oder Filtereinrichtung zum Einbringen in den Strahlengang ausgebildet wird in Abhängigkeit der Intensitätsverteilung des Strahlungsfeldes in der Kalibrierfläche derart, dass die Intensitätsverteilung des Strahlungsfeldes in der Bauebene nach dem Passieren der Korrektur- oder Filtereinrichtung homogen ist, wobei ein Absorptions- oder Reflexionsverhalten der Korrektur- oder Filtereinrichtung zeitlich konstant vorgesehen wird, wobei zur Ausbildung der Korrektur- oder Filtereinrichtung ein Träger bereitgestellt wird, dass auf dem Träger eine Korrektur- oder Filterschicht ausgebildet oder aufgebracht wird und dass die Korrektur- oder Filterschicht ausgebildet wird in Abhängigkeit der Intensitätsverteilung des Strahlungsfeldes in der Kalibrierfläche derart, dass die Intensitätsverteilung des Strahlungsfeldes in der Bauebene nach dem Passieren der Korrektur- oder Filtereinrichtung homogen ist.

Des Weiteren betrifft die Erfindung ein Verfahren zum Herstellen eines dreidimensionalen Objekts durch schichtweises Verfestigen eines unter Einwirkung von Strahlung verfestigbaren Materials, wobei die Strahlung mit einer optischen Abbildungseinrichtung in eine Bauebene abgebildet wird zum sukzessiven Ausbilden fester Objektschichten in der Bauebene, bei welchem Verfahren Soll-Schichtbilddaten für jede in der Bauebene zu verfestigende Objektschicht bereitgestellt werden, wobei eine Vorrichtung zur Korrektur einer inhomogenen Intensitätsverteilung eines durch die Strahlung definierten Strahlungsfeldes bereitgestellt und in einen Strahlengang zwischen eine die Strahlung erzeugende Strahlungsquelle und die Bauebene eingebracht wird und dass zum Bestrahlen der Bauebene ein Strahlungsfeld entsprechend den Soll-Schichtbilddaten erzeugt wird.

Außerdem betrifft die vorliegende Erfindung eine Vorrichtung zum Herstellen eines dreidimensionalen Objekts durch schichtweises Verfestigen eines unter Einwirkung von Strahlung verfestigbaren Materials, mit einer Strahlungsquelle zum Erzeugen der Strahlung und einer optischen Abbildungseinrichtung zum Abbilden eines von der Strahlungsquelle erzeugten Strahlungsfeldes in eine Bauebene.

Verfahren zum Herstellen einer Vorrichtung zur Korrektur einer inhomogenen Intensitätsverteilung eines von einer Strahlungsquelle erzeugten Strahlungsfeldes, insbesondere einer Strahlungsquelle einer Vorrichtung zum Herstellen dreidimensionaler Objekte durch schichtweises Verfestigen eines unter Einwirkung von Strahlung verfestigbaren Materials in einer Bauebene und Vorrichtungen zur Korrektur einer inhomogenen Intensitätsverteilung eines von einer Strahlungsquelle erzeugten Strahlungsfeldes, insbesondere einer Strahlungsquelle für eine Vorrichtung zum Herstellen dreidimensionaler Objekte durch schichtweises Verfestigen eines unter Einwirkung von Strahlung verfestigbaren Materials in einer Bauebene der eingangs beschriebenen Art sind in vielfältiger Weise bekannt, beispielsweise aus der DE 199 29 199 A1. Dreidimensionale Objekte werden dabei hergestellt mittels schichtweisem Aushärten oder Verschmelzen von vorzugsweise Kunststoffen mittels digitaler Maskenbelichtung, bei der der Energieeintrag pro Fläche in Abhängigkeit von der Lichtleistung über die Belichtungszeit gesteuert wird.

Bei der Herstellung dreidimensionaler Objekte mittels dieser Verfahren und Vorrichtungen ergeben sich verschiedene zu lösende Probleme. So ist es insbesondere wichtig, eine Lichtintensitätsverteilung zu homogenisieren. Bedingt durch ein zum Einsatz kommendes optisches System, welches insbesondere eine Strahlungsquelle und eine Projektionsoptik umfasst, ergibt sich in der Regel eine inhomogene Intensitätsverteilung bei der Abbildung. Eine solche Inhomogenität soll jedoch möglichst vermieden werden, so dass in einer Bau-Projektions-Ebene, nachfolgend auch einfach als Bauebene bezeichnet, in welcher das dreidimensionale Objekt entsteht, die Intensitätsverteilung des von der Strahlungsquelle und einer optischen Abbildungseinrichtung, nachfolgend als optisches System bezeichnet, erzeugten Strahlungsfeldes möglichst homogen ist.

Aus der US 2008/0038396 A1 sind Vorrichtungen und Verfahren zum Herstellen eines dreidimensionalen Objekts mittels Maskenbelichtung bekannt. In der DE 93 19 405 U1 ist eine Vorrichtung zur Herstellung eines dreidimensionalen Objekts nach dem Prinzip der Photoverfestigung beschrieben. Verfahren und Vorrichtungen zum Herstellen eines dreidimensionalen Objekts sowie Belichtungsmaskenerzeugungsvorrichtungen sind in der DE 10 2013 107 571 A1 offenbart. Die DE 26 46 022 A1 betrifft einen Lichtstärkeverteilungs-Korrekturfilter sowie dessen Herstellverfahren. Einrichtungen zum gleichmäßigen Ausleuchten einer Fläche, insbesondere für Reproduktionszwecke, sowie Verfahren zur Herstellung der Einrichtungen sind aus der CH 405 752 A bekannt. Verfahren und Vorrichtungen zum optischen Pumpen von Laserverstärkern für die Erzeugung einer Laserstrahlung mit definierten Strahleigenschaften sind in der DE 10 2013 005 607 A1 beschrieben.

Es ist daher eine Aufgabe der vorliegenden Erfindung, ein System sowie Verfahren und eine Vorrichtung der eingangs beschriebenen Art so zu verbessern, dass die Herstellung eines dreidimensionalen Objekts auf einfache Weise erfolgen kann.

Diese Aufgabe wird bei einem System der eingangs beschriebenen Art erfindungsgemäß dadurch gelöst, dass die Korrektur- oder Filterschicht mindestens zwei Korrektur- oder Filterschichtbereiche aufweist, welche einen minimalen und einen maximalen Strahlungsschwächungswert aufweisen, dass eine Differenz zwischen dem minimalen und dem maximalen Strahlungsschwächungswert einer Differenz zwischen einer minimalen und einer maximalen Strahlungsintensität des Strahlungsfeldes in einer Kalibrierfläche zwischen der Strahlungsquelle und der Bauebene oder in der Bauebene entspricht, dass die Kalibrierfläche gerastert ist und eine Mehrzahl von Kalibrierflächenpixeln definiert, dass die Korrektur- oder Filterschicht eine der Mehrzahl von Kalibrierflächenpixeln entsprechende Mehrzahl von Korrektur- oder Filterschichtpixeln umfasst und dass ein Strahlungsschwächungswert jedes Korrektur- oder Filterschichtpixels an die Intensität der auf dieses Korrektur- oder Filterschichtpixel auftreffenden Strahlung der Strahlungsquelle angepasst ist derart, dass die Intensität des Strahlungsfeldes nach dem Passieren des Korrektur- oder Filterschichtpixels für alle Korrektur- oder Filterschichtpixel identisch oder im Wesentlichen identisch ist.

Mit der Korrektur- oder Filtereinrichtung kann somit insbesondere eine Inhomogenität des Strahlungsfeldes weitgehend, idealerweise vollständig, kompensiert werden. In jedem Fall kann mit der Korrektur- oder Filtereinrichtung das Strahlungsfeld im Vergleich zum Strahlungsfeld ohne Korrektur- oder Filtereinrichtung deutlich homogenisiert werden. Dazu ist die Korrektur- oder Filtereinrichtung insbesondere derart ausgebildet, dass sie an die allgemeine oder individuelle Inhomogenität des Strahlungsfeldes angepasst ist, also selbst auch nicht homogen ausgebildet ist, sondern entsprechend der Inhomogenität des Strahlungsfeldes inhomogene Filtereigenschaften aufweist. So kann genau dort, wo das Strahlungsfeld eine höhere Intensität aufweist, eine stärkere Abschwächung erfolgen als dort, wo das Strahlungsfeld eine niedrigere Intensität aufweist. Vorzugsweise wird die Korrektur- oder Filtereinrichtung derart ausgebildet, dass das Strahlungsfeld in den Bereichen, in denen die Intensität des Strahlungsfeldes minimal ist, keine Abschwächung erfolgt. So kann insbesondere eine übermäßige Erwärmung der Korrektur- oder Filtereinrichtung vermieden und zudem auch eine Vernichtung von Strahlung minimiert werden. Insbesondere kann die Korrektur- oder Filtereinrichtung für einen Einsatz in Absorption oder in Reflexion ausgebildet sein. Unter einer allgemeinen Inhomogenität ist insbesondere eine Inhomogenität des optischen Systems zu verstehen, die auf Abschwächungen der Intensität in Randbereichen aufgrund des verwendeten Typs der Abbildungseinrichtungen zurückgeht. Unter einer individuellen Inhomogenität ist insbesondere eine Inhomogenität zu verstehen, die das individuelle optische System, also insbesondere die Strahlungsquelle in Verbindung mit der Abbildungseinrichtung, verursacht. Gemäß der Erfindung ist ein Absorptions- oder Reflexionsverhalten der Korrektur- oder Filtereinrichtung zeitlich konstant. Dies bedeutet insbesondere, dass sich ein Absorptions- oder Reflexionsverhalten der Korrektur- oder Filtereinrichtung zeitlich nicht ändert. Dies ist beispielsweise der Fall bei einem Träger mit einer Korrektur- oder Filterschicht, die sich zeitlich nicht ändert, sondern allenfalls auf einer langen Zeitskala aufgrund der einwirkenden Strahlung zur Herstellung dreidimensionaler Objekte etwas ausbleicht. In jedem Fall ist für eine Korrektur- oder Filtereinrichtung mit einem zeitlich konstanten Absorptionsverhalten keine besondere Steuerung der Vorrichtung und keine Berechnung einer Korrektur der Intensitätsverteilung des Strahlungsfeldes erforderlich. Auf diese Weise lassen sich Herstellungskosten für eine Vorrichtung zur Herstellung dreidimensionaler Objekte deutlich senken. Es ist lediglich eine einmalige, oder nur nach mehreren Monaten zu wiederholende Vermessung des Strahlungsfeldes sowie eine entsprechend an die Inhomogenität der Intensitätsverteilung des Strahlungsfeldes angepasste Korrektur- oder Filtereinrichtung erforderlich, um dreidimensionale Objekte optimaler Qualität herstellen zu können. Eine wiederkehrende Vermessung ist insbesondere dann sinnvoll, wenn sich das Strahlungsfeld über die Zeit ändert, so dass jährlich oder im Rhythmus einiger Monate die Inhomogenität der Intensitätsverteilung des Strahlungsfeldes neu vermessen und eine daran angepasste Korrektur- oder Filtereinrichtung geändert oder neu hergestellt werden kann. Günstig ist es, dass die Korrektur- oder Filtereinrichtung einen Träger und mindestens eine auf dem Träger ausgebildete oder aufgebrachte Korrektur- oder Filterschicht umfasst. Ein Träger lässt sich auf einfache Weise handhaben. Dieser kann insbesondere starr oder im Wesentlichen starr oder aber auch flexibel ausgebildet sein. Die Korrektur- oder Filterschicht kann auch mehrere Schichten oder Lagen umfassen, die insbesondere zur Absorption elektromagnetischer Strahlung in unterschiedlichen Wellenlängenbereichen optimiert sein können. Die Korrektur- oder Filterschicht kann optional durch eine digitale Struktur ausgebildet werden, also insbesondere kleinste Flächenbereiche, die vollständig absorbieren beziehungsweise reflektieren, beispielsweise indem sie geschwärzt sind, so dass beispielsweise optische Pixel gebildet werden durch eine Mehrzahl von geschwärzten Flächenbereichen und nicht geschwärzten Flächenbereichen des Trägers. Insbesondere kann die Korrektur- oder Filterschicht gerastert sein, vorzugsweise mit einer Auflösung, die größer, insbesondere deutlich größer, ist als eine Auflösung eines Pixelrasters, das zur Belichtung des verfestigbaren Materials eingesetzt wird. In der beschriebenen Weise lässt sich so eine Korrektur- oder Filtereinrichtung individuell für jede Strahlungsquelle erzeugen und damit allgemein oder individuell für jede Vorrichtung zum Herstellen dreidimensionaler Objekte. Die Korrektur- oder Filtereinrichtung kann beispielsweise nach dem Einbau der Strahlungsquelle durch einmaliges Ausmessen des Strahlungsfeldes gemessen oder bestimmt werden. Anhand der Inhomogenität des gemessenen Strahlungsfeldes kann dann die Korrektur- oder Filtereinrichtung individuell erzeugt werden, beispielsweise durch Aufbringen einer entsprechenden Korrektur- oder Filterschicht auf den Träger. Eine allgemeine Anpassung kann beispielsweise erfolgen, indem typische Bereiche mit höherer Intensität stärker gefiltert, also abgeschwächt, werden, ohne die individuelle Charakteristik des individuellen optischen Systems zu korrigieren. Die Korrektur- oder Filterschicht kann auf beliebige Weise aufgebracht sein, beispielsweise eine reflektierende Korrektur- oder Filterschicht zum mindestens teilweisen Ablenken der Strahlung durch chemische oder physikalische Abscheidungsverfahren wie CVD oder PVD. Vorteilhaft ist es, dass die Korrektur- oder Filterschicht mindestens zwei Korrektur- oder Filterschichtbereiche aufweist, welche einen minimalen und einen maximalen Strahlungsschwächungswert aufweisen, und wenn eine Differenz zwischen dem minimalen und dem maximalen Strahlungsschwächungswert einer Differenz zwischen einer minimalen und einer maximalen Strahlungsintensität des Strahlungsfeldes in einer Kalibrierfläche zwischen der Strahlungsquelle und der Bauebene oder in der Bauebene entspricht. Diese Ausgestaltung ermöglicht es insbesondere, nur so viel von der Strahlung zu absorbieren, wie erforderlich ist, um das Strahlungsfeld in der Kalibrierfläche und/oder in der Bauebene vollständig zu homogenisieren. Die Kalibrierfläche kann insbesondere eine beliebige Fläche sein, die zwischen der Strahlungsquelle und der Bauebene definiert wird. Sie kann aber auch durch die Bauebene selbst definiert werden, insbesondere durch den Flächenbereich, der durch das zu verfestigende Material im dafür vorgesehenen Behälter definiert wird. Gekrümmte Kalibrierflächen werden vorzugsweise dann gewählt, wenn die Korrektur- oder Filterschicht ebenfalls gekrümmt ist. Beispielsweise kann dies der Fall sein, wenn die Korrektur- oder Filterschicht auf einer Oberfläche einer optischen Linse aufgebracht wird, welche gekrümmt ist, oder auf einem gekrümmten Spiegel. Insbesondere kann der minimale Strahlungsschwächungswert Null oder etwa Null sein, so dass im Korrektur- oder Filterschichtbereich mit dem minimalen Strahlungsschwächungswert kein oder praktisch keine Strahlung absorbiert wird. Dies wird vorzugweise für die Bereiche so gewählt, in denen das Strahlungsfeld in der Kalibrierfläche eine minimale Intensität aufweist. Vorteilhaft ist es, dass die Kalibrierfläche gerastert ist und eine Mehrzahl von Kalibrierflächenpixeln definiert, wenn die Korrektur- oder Filterschicht eine der Mehrzahl von Kalibrierflächenpixeln entsprechende Mehrzahl von Korrektur- oder Filterschichtpixeln umfasst und wenn ein Strahlungsschwächungswert jedes Korrektur- oder Filterschichtpixels an die Intensität der auf dieses Korrektur- oder Filterschichtpixel auftreffenden Strahlung der Strahlungsquelle angepasst ist derart, dass die Intensität des Strahlungsfeldes nach dem Passieren des Korrektur- oder Filterschichtpixels für alle Korrektur- oder Filterschichtpixel identisch oder im Wesentlichen identisch ist. Identisch oder im Wesentlichen identisch ist dabei so zu verstehen, dass die Strahlungsintensität nach Möglichkeit identisch sein soll, zumindest jedoch homogener als ohne Korrektur- oder Filtereinrichtung ist. Wie bereits erwähnt, kann die Zahl der Kalibrierflächenpixel und damit auch der Korrektur- oder Filterschichtpixeln die Zahl der optischen Pixel, die für die Ausbildung des dreidimensionalen Objekts eingesetzt werden, übersteigen. Damit lässt sich die Korrektur- oder Filterschicht selbst gerastert ausbilden und beispielsweise Rasterbildes ausbilden.

Vorzugsweise ist die Korrektur- oder Filterschicht ausgebildet zum mindestens teilweisen Absorbieren von Strahlung oder zum mindestens teilweisen Ablenken von Strahlung aus dem Strahlungsfeld, welche Strahlung mit der Strahlungsquelle erzeugt wird. Insbesondere muss die Korrektur- oder Filterschicht dort mehr Strahlung absorbieren, wo die Intensität des Strahlungsfeldes höher ist als ein Minimalwert des Strahlungsfeldes. Wie beschrieben kann dies durch unterschiedliche Abstufungen erfolgen, beispielsweise durch eine unterschiedliche Dicke der Korrektur- oder Filterschicht, oder aber durch eine zusätzliche Rasterung jedes optischen Pixels, welches zur Ausbildung des dreidimensionalen Objekts genutzt wird, und zwar durch eine Rasterung mit deutlich höherer Auflösung, also praktisch eine Subpixelrasterung jedes optischen Pixels. Dies kann beispielsweise auf einfache Weise dadurch erreicht werden, dass die Korrektur- oder Filtereinrichtung im Strahlengang dort eingebracht wird, wo das Strahlungsfeld maximal flächig aufgeweitet ist. Auf diese Weise kann die Korrektur- oder Filterschicht mit einer konstanten Schichtdicke aufgebracht werden, wobei die Korrektur- oder Filterschicht dann den Träger nicht vollständig flächig bedeckt, sondern eben nur einzelne Bereiche, beispielsweise Trägerpixel des Trägers. Zum mindestens teilweisen Ablenken von Strahlung aus dem Strahlungsfeld kann die Korrektur- oder Filterschicht teilweise reflektierend ausgebildet werden, so dass aus dem Strahlungsfeld genau dort Strahlung durch Ablenkung eliminiert oder entfernt wird, wo hohe Intensitäten auftreten. Dies kann ebenfalls mit einer Subpixelrasterung erreicht werden, dass also genau dort, wo eine Abschwächung gewünscht wird, Trägerpixel reflektierend ausgebildet werden, die gezielt Strahlung aus dem Strahlungsfeld ablenken, so dass sie nicht mehr auf die Bauebene trifft.

Um die Vorrichtung möglichst flexibel einsetzen zu können, ist es günstig, wenn die Korrektur- oder Filterschicht ausgebildet ist zum Absorbieren und Ablenken von Strahlung in einem Wellenlängenbereich von etwa 200 nm bis etwa 900 nm. Insbesondere ist es vorteilhaft, wenn die Korrektur- oder Filterschicht Strahlung in einem Wellenlängenbereich von etwa 350 nm bis etwa 550 nm absorbiert oder reflektiert. Eine solche Korrektur- oder Filterschicht eignet sich insbesondere für alle Arten von elektromagnetischen Strahlungsquellen, welche Licht im nahen Ultraviolett-Bereich, sichtbaren Spektralbereich sowie nahen Infrarot-Bereich aussenden. Dies können insbesondere Leuchtdioden oder Laserdioden mit klar definierten Linienspektren sein.

Gemäß einer weiteren bevorzugten Ausführungsform der Erfindung kann vorgesehen sein, dass der Träger mindestens teilweise für Strahlung durchlässig oder mindestens teilweise Strahlung reflektierend ausgebildet ist. Je nachdem, ob der Träger vom Strahlungsfeld durchstrahlt wird oder das Strahlungsfeld umlenkt, ist es günstig, wenn der Träger entweder die Strahlung durchlassen oder diese reflektieren kann. Insbesondere kann so eine Korrektur von Intensitätsinhomogenitäten des von der Strahlungsquelle erzeugten Strahlungsfeldes sowohl in Absorption als auch in Reflexion erfolgen.

Besonders kompakt ausbilden lässt sich die Vorrichtung, wenn der Träger in Form einer optischen Linse, eines optischen Spiegels, einer Glasplatte, einer Kunststoffplatte, einer Kunststofffolie oder eines transparenten oder reflektierenden Materials ausgebildet ist. Derartige Träger ermöglichen es, insbesondere eine Doppelfunktion auszuüben. Zum einen bilden sie optische Elemente einer Abbildungseinrichtung einer Vorrichtung zum Herstellen dreidimensionaler Objekte, zum anderen dienen sie der Korrektur von Intensitätsinhomogenitäten des von der Strahlungsquelle erzeugten Strahlungsfeldes. Insbesondere lassen sich ebene Träger besonders einfach beschichten und handhaben. Beispielsweise kann eine Glas- oder Kunststoffplatte oder auch eine durchsichtige Kunststofffolie direkt parallel zur Bauebene angeordnet werden, zum Beispiel direkt ober- oder unterhalb des Behälters, in dem sich das zu verfestigende Material befindet.

Besonders kostengünstig herstellen lässt sich die Korrektur- oder Filtereinrichtung, wenn die Korrektur- oder Filterschicht auf den Träger aufgedruckt ist. Beispielsweise können so Glasplatten oder Kunststofffolien bedruckt werden. Vorzugsweise werden die Träger gerastert bedruckt, und zwar mit einer höheren Auflösung als die Auflösung des herzustellenden dreidimensionalen Objekts. Dies ermöglicht es insbesondere, zunächst das Strahlungsfeld der Strahlungsquelle zu vermessen und dann direkt beispielsweise mit einem herkömmlichen Laserdrucker eine Kunststofffolie zu bedrucken und diese dann als Korrektur- oder Filtereinrichtung zu nutzen.

Die der Erfindung zugrundeliegende Aufgabe wird ferner bei einem Verfahren der eingangs beschriebenen Art erfindungsgemäß dadurch gelöst, dass ein Minimalwert und ein Maximalwert der Intensitätsverteilung der Strahlung in der Kalibrierfläche gemessen werden und dass derjenige Flächenbereich der Korrektur- oder Filterschicht, zu welchem der Minimalwert der Intensitätsverteilung in der Kalibrierfläche korrespondiert, mit einem Minimalabsorptionswert für die Strahlung ausgebildet wird, dass derjenige Flächenbereich der Korrektur- oder Filterschicht, zu welchem der Maximalwert der Intensitätsverteilung korrespondiert, mit einem Maximalabsorptionswert der Strahlung ausgebildet wird, dass die Kalibrierfläche gerastert wird und eine Mehrzahl von Kalibrierflächenpixeln definiert, dass die Korrektur- oder Filterschicht eine der Mehrzahl von Kalibrierflächenpixeln entsprechende Mehrzahl von Korrektur- oder Filterschichtpixeln umfasst und dass ein Strahlungsschwächungswert jedes Korrektur- oder Filterschichtpixels an die Intensität der auf dieses Korrektur- oder Filterschichtpixel auftreffenden Strahlung der Strahlungsquelle angepasst wird derart, dass die Intensität der Strahlung nach dem Passieren des Korrektur- oder Filterschichtpixels für alle Korrektur- oder Filterschichtpixel identisch ist.

Wie bereits oben beschrieben, wird also einmalig in einer Kalibrierfläche, beispielsweise in der Bauebene, eine Intensitätsverteilung des Strahlungsfeldes der verwendeten Strahlungsquelle vermessen und eine Korrektur- oder Filtereinrichtung zur Kompensation der Inhomogenitäten ausgebildet. Die Korrektur- oder Filtereinrichtung wird dabei so ausgebildet, dass die Intensitätsverteilung des Strahlungsfeldes in der Bauebene nach dem Passieren der Korrektur- oder Filtereinrichtung homogen oder zumindest homogener als ohne die Korrektur- oder Filtereinrichtung ist. Das Absorptions- oder Reflexionsverhalten der Korrektur- oder Filtereinrichtung wird zeitlich konstant vorgesehen. Dies bedeutet insbesondere, dass sich ein Absorptions- oder Reflexionsverhalten der Korrektur- oder Filtereinrichtung zeitlich nicht ändert. Dies ist beispielsweise der Fall bei einem Träger mit einer Korrektur- oder Filterschicht, die sich zeitlich nicht ändert, sondern allenfalls auf einer langen Zeitskala aufgrund der einwirkenden Strahlung zur Herstellung dreidimensionaler Objekte etwas ausbleicht. In jedem Fall ist für eine Korrektur- oder Filtereinrichtung mit einem zeitlich konstanten Absorptionsverhalten keine besondere Steuerung der Vorrichtung und keine Berechnung einer Korrektur der Intensitätsverteilung des Strahlungsfeldes erforderlich. Auf diese Weise lassen sich Herstellungskosten für eine Vorrichtung zur Herstellung dreidimensionaler Objekte deutlich senken. Es ist lediglich eine einmalige, oder nur nach mehreren Monaten zu wiederholende Vermessung des Strahlungsfeldes sowie eine entsprechend an die Inhomogenität der Intensitätsverteilung des Strahlungsfeldes angepasste Korrektur- oder Filtereinrichtung erforderlich, um dreidimensionale Objekte optimaler Qualität herstellen zu können. Eine wiederkehrende Vermessung ist insbesondere dann sinnvoll, wenn sich das Strahlungsfeld über die Zeit ändert, so dass jährlich oder im Rhythmus einiger Monate die Inhomogenität der Intensitätsverteilung des Strahlungsfeldes neu vermessen und eine daran angepasste Korrektur- oder Filtereinrichtung geändert oder neu hergestellt werden kann. Günstig ist es, dass zur Ausbildung der Korrektur- oder Filtereinrichtung ein Träger bereitgestellt wird, dass auf dem Träger eine Korrektur- oder Filterschicht ausgebildet oder aufgebracht wird und dass die Korrektur- oder Filterschicht ausgebildet wird in Abhängigkeit der Intensitätsverteilung des Strahlungsfeldes in der Kalibrierfläche derart, dass die Intensitätsverteilung des Strahlungsfeldes in der Bauebene nach dem Passieren der Korrektur- oder Filtereinrichtung homogen ist. Auf diese Weise kann die Korrektur- oder Filterschicht beliebig dünn ausgebildet werden. Die Korrektur- oder Filterschicht muss nicht zwingend den Träger flächig bedecken. Es ist insbesondere auch möglich, den Träger gerastert mit absorbierenden Bereichen oder Pixeln zu versehen, so dass auf diese Weise in einem bestimmten Flächenbereich nur ein Teil der Strahlung durch den Träger hindurch gelangen oder von diesem reflektiert werden kann. Gemäß dem erfindungsgemäßen Verfahren ist vorgesehen, dass ein Minimalwert und ein Maximalwert der Intensitätsverteilung der Strahlung in der Kalibrierfläche gemessen werden und dass derjenige Flächenbereich der Korrektur- oder Filterschicht, zu welchem der Minimalwert der Intensitätsverteilung in der Kalibrierfläche korrespondiert, mit einem Minimalabsorptionswert für die Strahlung ausgebildet wird und dass derjenige Flächenbereich der Korrektur- oder Filterschicht, zu welchem der Maximalwert der Intensitätsverteilung korrespondiert, mit einem Maximalabsorptionswert der Strahlung ausgebildet wird. Durch diese Vorgehensweise lässt sich insbesondere ermitteln, welche Flächenbereiche des Strahlungsfeldes nicht abgeschwächt werden müssen. So kann die Korrektur- oder Filterschicht insbesondere derart ausgebildet werden, dass nur diejenigen Flächenbereiche, in denen eine Strahlungsintensität größer als ein Minimalwert der Intensitätsverteilung ist, abgeschwächt werden. Ferner ist es günstig, dass die Kalibrierfläche gerastert wird und eine Mehrzahl von Kalibrierflächenpixel definiert, dass die Korrektur- oder Filterschicht eine der Mehrzahl von Kalibrierflächenpixeln entsprechende Mehrzahl von Korrektur- oder Filterschichtpixeln umfasst und dass ein Strahlungsschwächungswert jedes Korrektur- oder Filterschichtpixels an die Intensität der auf dieses Korrektur- oder Filterschichtpixel auftreffenden Strahlung der Strahlungsquelle angepasst wird derart, dass die Intensität der Strahlung nach dem Passieren des Korrektur- oder Filterschichtpixels für alle Korrektur- oder Filterschichtpixel identisch ist. Diese Ausgestaltung des Verfahrens ermöglicht es insbesondere, die Korrektur- oder Filterschicht gerastert auszubilden. Vorzugsweise ist dabei eine Auflösung der Rasterung der Kalibrierfläche größer als eine Auflösung der zur Ausbildung des dreidimensionalen Objekts definierten Bildpunkte. Insbesondere können pro Bildpunkt des dreidimensionalen Objekts zwei oder mehr Kalibrierflächenpixel definiert werden.

Vorteilhaft ist es, wenn die Intensitätsverteilung der Strahlungsquelle in einer Kalibrierfläche gemessen wird, welche eine Kalibrierebene definiert. Das Messen einer Intensitätsverteilung in einer Ebene ist deutlich einfacher als in einer gekrümmten Fläche. Beispielsweise kann die Kalibrierebene mit der Bauebene zusammenfallen. Das Vermessen der Intensitätsverteilung der Strahlungsquelle in der Kalibrierfläche kann beispielsweise mit dafür geeigneten Strahlungsmessern oder gleichzeitig für eine Mehrzahl von Flächenbereichen oder Pixeln mit einem strahlungssensitiven, gerasterten Strahlungsdetektor erfolgen, beispielsweise in Form eines CCD-Chips.

Vorzugsweise wird als Träger eine optische Linse, ein optischer Spiegel, eine Glasplatte, eine Kunststoffplatte oder eine Kunststofffolie bereitgestellt. Insbesondere können derartige Träger Teile einer Abbildungseinrichtung einer Vorrichtung zum Herstellen dreidimensionaler Objekte bilden. Sie lassen sich auf einfache Weise handhaben und an der Vorrichtung zum Herstellen dreidimensionaler Objekte anbringen, beispielsweise in speziell dafür vorgesehenen Halterungen.

Auf besonders einfache Weise ausbilden lässt sich die Korrektur- oder Filterschicht, wenn der Träger zur Ausbildung derselben bedruckt wird. Insbesondere kann der Träger zur Ausbildung der Korrektur- oder Filterschicht gerastert bedruckt werden. Wie bereits oben dargelegt, kann eine Auflösung des Rasters zur Ausbildung der Korrektur- oder Filterschicht, größer, insbesondere deutlich größer, sein als eine Auflösung des die Bildpunkte zur Ausbildung des dreidimensionalen Objekts vorgebenden Bildpunkterasters beziehungsweise Pixelrasters.

Günstig ist es, wenn die Korrektur- oder Filterschicht derart ausgebildet wird, dass eine Differenz zwischen dem Maximalwert und dem Minimalwert der Intensitätsverteilung des Strahlungsfeldes einer Differenz zwischen dem Maximalabsorptionswert und dem Minimalabsorptionswert entspricht. Auf diese Weise kann sichergestellt werden, dass durch die Korrektur- oder Filtereinrichtung nicht mehr Strahlung absorbiert wird als unbedingt erforderlich.

Die eingangs gestellte Aufgabe wird ferner bei einem Verfahren zum Herstellen eines dreidimensionalen Objekts der eingangs beschriebenen Art erfindungsgemäß dadurch gelöst, dass ein System in Form eines der oben beschriebenen vorteilhaften Systeme bereitgestellt wird und dass die Vorrichtungen zur Korrektur einer inhomogen Intensitätsverteilung der Strahlung in einen Strahlengang zwischen die die Strahlung erzeugende Strahlungsquelle und die Bauebene eingebracht wird.

Das vorgeschlagene Verfahren ermöglicht es insbesondere, ohne ständig eine rechnerische Korrektur der Belichtungsintensitäten vornehmen zu müssen, dreidimensionale Objekte mit hoher Qualität herzustellen. Da keine Berechnungen zur Homogenisierung des Strahlungsfeldes erforderlich sind, können dreidimensionale Objekte schneller ausgebildet werden. Zur Kompensation der Inhomogenitäten des Strahlungsfeldes, welches durch eine Strahlungsquelle erzeugt wird, wird lediglich eine Vorrichtung zur Korrektur einer inhomogenen Intensitätsverteilung des Strahlungsfeldes bereitgestellt und in den Strahlengang in der angegebenen Weise eingebracht. Weitere Korrekturen sind optional möglich, um insbesondere in der Bauebene eine noch bessere Homogenität des Strahlungsfeldes zu erreichen.

Günstig ist es, wenn eine der oben beschriebenen vorteilhaften Vorrichtungen zur Korrektur einer inhomogenen Intensitätsverteilung der Strahlung bereitgestellt und in einen Strahlengang zwischen eine die Strahlung erzeugende Strahlungsquelle und die Bauebene eingebracht wird.

Eine der oben beschriebenen vorteilhaften Vorrichtungen zur Korrektur einer inhomogenen Intensitätsverteilung der Strahlung einzusetzen, bietet dann insbesondere auch die oben beschriebenen Vorteile.

Ferner wird die eingangs gestellte Aufgabe bei einer Vorrichtung zum Herstellen eines dreidimensionalen Objektes der eingangs beschriebenen Art erfindungsgemäß dadurch gelöst, dass sie eines der oben beschriebenen vorteilhaften Systeme umfassend eine Strahlungsquelle und eine Vorrichtung zur Korrektur inhomogener Intensitätsverteilungen umfasst.

Eine auf diese Weise weitergebildete Vorrichtung zum Herstellen eines dreidimensionalen Objekts weist dann ebenfalls die oben im Zusammenhang mit vorteilhaften Ausführungsformen von Vorrichtungen zur Korrektur inhomogener Intensitätsverteilungen beschriebenen Vorteile auf.

Günstig ist es, wenn die Strahlungsquelle mindestens eine Leuchtdiode oder mindestens eine Laserdiode umfasst. Mit derartigen Strahlungsquellen lassen sich relativ homogene Strahlungsfelder erzeugen, die zudem eine große Langzeitkonstanz aufweisen.

Ferner betrifft die Erfindung eine Verwendung einer Vorrichtung zum Herstellen eines dreidimensionalen Objekts durch schichtweises Verfestigen eines unter Einwirkung von Strahlung verfestigbaren Materials wie sie oben beschrieben wurde zur Durchführung eines Verfahrens zum Herstellen eines dreidimensionalen Objekts durch schichtweises Verfestigen eines unter Einwirkung von Strahlung verfestigbaren Materials, wie es ebenfalls oben beschrieben wurde.

Mit den beschriebenen Vorrichtungen lassen sich die beschriebenen Verfahren insbesondere vorteilhaft durchführen.

Die nachfolgende Beschreibung dient im Zusammenhang mit den Zeichnungen der näheren Erläuterung. Es zeigen:
- Figur 1:: eine schematische Darstellung eines Teils einer Vorrichtung zum Herstellen eines dreidimensionalen Objekts;
- Figur 2:: eine schematische Ansicht eines weiteren Teils einer Vorrichtung zum Herstellen eines dreidimensionalen Objekts;
- Figur 3:: eine schematische Ansicht eines weiteren Teils eines zweiten Ausführungsbeispiels einer Vorrichtung zum Herstellen eines dreidimensionalen Objekts;
- Figur 4:: eine schematische Darstellung eines Strahlungsfeldes einer Strahlungsquelle;
- Figur 5:: eine schematische Darstellung einer Korrektur- oder Filtereinrichtung zur Kompensation des in Figur 4 schematisch dargestellten Strahlungsfeldes;
- Figur 6:: eine schematische Draufsicht einer Linse mit Korrektur- oder Filterschicht;
- Figur 7:: eine Schnittansicht längs Linie 7-7 in Figur 6; und
- Figur 8:: eine schematische Schnittansicht eines Umlenkspiegels mit Korrektur- oder Filterschicht.

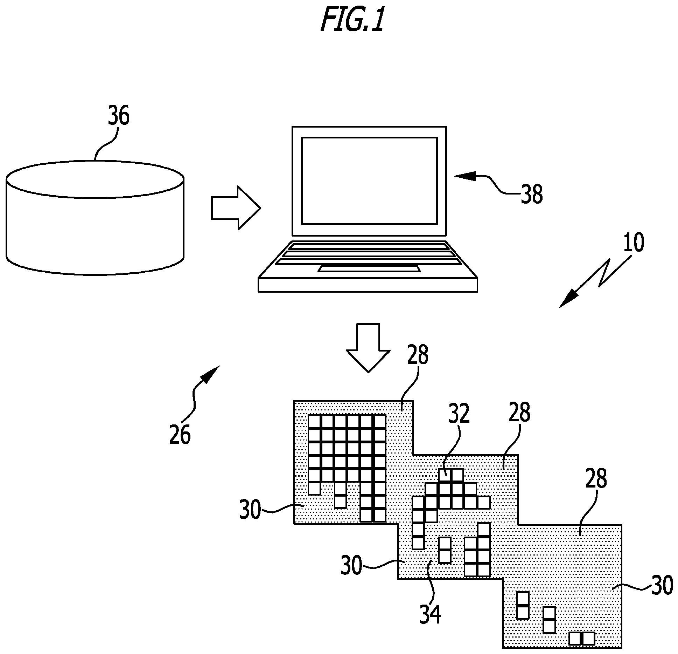

Der schematische Aufbau einer Vorrichtung 10 zum Herstellen eines dreidimensionalen Objekts 12 durch schichtweises Verfestigen eines unter Einwirkung von ein Strahlungsfeld 13 definierender Strahlung 14 verfestigbaren Materials 16 ist schematisch in den Figuren 1 bis 3 für zwei verschiedene Aufbauvarianten dargestellt.

Die Vorrichtung 10 umfasst eine Strahlungsquelle 18, welche eine Abbildungsoptik 20 zum Abbilden eines Objektschichtbildes in eine Bild-/Bauebene 22, nachfolgend auch einfach als Bauebene bezeichnet, umfasst. Von der Abbildungsoptik 20 umfasst ist eine Maskeneinheit 24, welche durch eine Belichtungsmaskenerzeugungseinrichtung 26 ansteuerbar ist. Mit der Belichtungsmaskenerzeugungseinrichtung 26 kann für jede Objektschicht des Objekts 12 eine Belichtungsmaske 28 generiert werden, und zwar in Form eines 2-Bit-Bitmaps 30. Jede 2-Bit-Bitmap 30 weist also lediglich zwei Bit-Werte 32 und 34 auf, wobei der Bit-Wert 32 eine größere Durchlässigkeit für die Strahlung 14 ermöglicht als der Bit-Wert 34. Im Extremfall kann der Bit-Wert 32 für die Strahlung 14 vollständig "durchlässig" sein, der Bit-Wert 34 für die Strahlung 14 vollständig "nicht durchlässig". In jedem Fall ist die Durchlässigkeit der Pixel der 2-Bit-Bitmap 30 mit dem Bit-Wert 32 größer als die Durchlässigkeit der Pixel mit dem Bit-Wert 34.

Die Belichtungsmaskenerzeugungseinrichtung 26 umfasst ferner eine Speichereinrichtung 36, welche beispielsweise gespeicherte native Informationen für die auszubildenden Objektschichten des auszubildenden Objekts 12 enthalten kann. Diese können insbesondere auf einen Computer 38 oder eine andere hierfür geeignete Recheneinrichtung übertragen werden. In Abhängigkeit der Schichtinformationen wird mit dem Computer 38 eine 2-Bit-Bitmap 30 berechnet, die dann auf die Maskeneinheit 24 übertragen wird, um beispielsweise ein LCD-Display bei Belichtung in Transmission oder eine digitale Mikrospiegeleinrichtung mit mindestens einem Umlenkspiegel ansteuern, um so die von der Strahlungsquelle 18 erzeugte Strahlung 14 entsprechend der auszubildenden Objektschicht auf die Bild-/Bauebene 22 abzubilden. In der Bild-/Bauebene 22 trifft die Strahlung 14 auf noch unverfestigtes, viskoses Material 16, das durch den Energieeintrag durch Belichtung nach einer bestimmten Zeit in Abhängigkeit des Materials sowie der Strahlungsintensität verfestigt wird. Für jede Objektschicht kann eine individuelle Belichtungszeit vorgegeben werden, so dass beispielsweise die Maskeneinheit 24 die Strahlung 14 vollständig zurückhält, wenn keine Objektschicht ausgebildet werden soll, und die Strahlung 14 selektiv durchlässt, wenn eine Objektschicht ausgebildet werden soll.

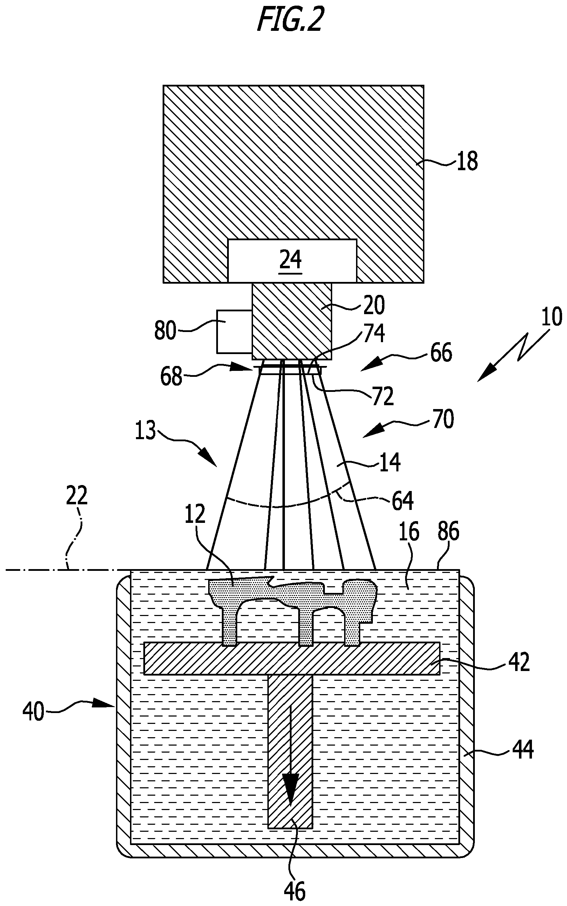

Zur Ausbildung von Objekten 12 kommen insbesondere zwei Arten von Trägersystemen 40 zum Einsatz. Bei der in Figur 2 schematisch dargestellten Variante befindet sich eine Trägerplatte 42 in einem mit dem Material 16 befüllten Behälter 44. Die Trägerplatte 42 ist mit einer Antriebseinrichtung 46 in den Behälter 44 hinein bewegbar, vorzugsweise in vorgegebenen, diskreten Schritten, die immer dann vollzogen werden, wenn eine weitere Objektschicht durch Aushärten des Materials an der Oberfläche des bereits teilweise ausgebildeten Objekts 12 verfestigt ist und so eine weitere Objektschicht bildet.

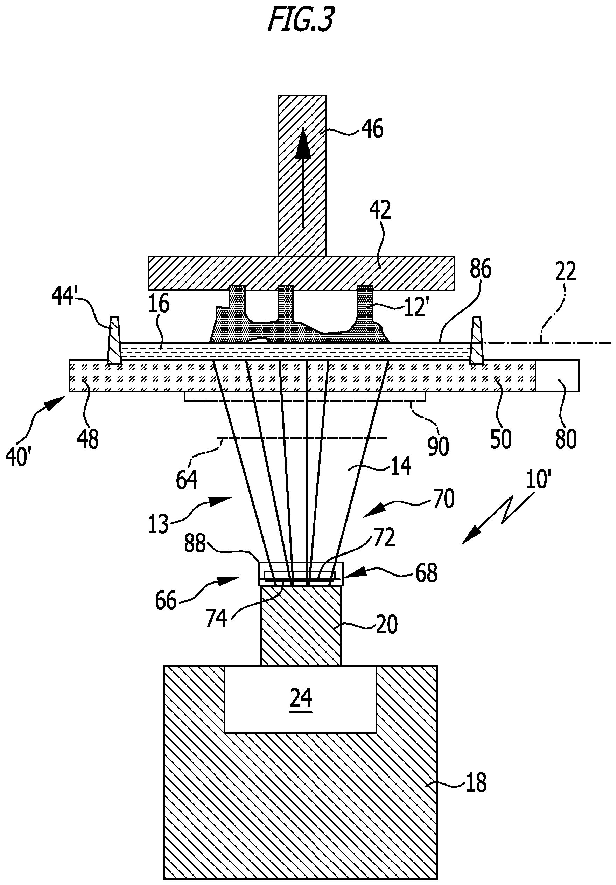

Alternativ kann, wie bei dem schematisch in Figur 3 dargestellten Trägersystem 40', die Strahlung 14 auch durch eine strahlungsdurchlässige Platte 48, die einen Boden 50 des alternativen Behälters 44' bildet, in die Bild-/Bauebene 22 abgebildet werden. Die auszubildende Objektschicht entsteht ebenfalls durch Energieeintrag in der Bild-/Bauebene 22, und zwar unter der zuletzt ausgebildeten Objektschicht. Ist eine Objektschicht ausgehärtet, wird mittels der Antriebseinheit 46 das bereits ausgebildete Objekt 12 in vorgegebener Weise ein Stück, insbesondere eine Strecke, die einer Dicke der neu ausgebildeten Objektschicht entspricht, vom Behälter 44' weg bewegt, also quasi etwas aus diesem herausgezogen. Nun kann in einem nächsten Schritt die nächste Objektschicht durch Belichtung des Materials 16 in der Bild-/Bauebene 22 hergestellt werden.

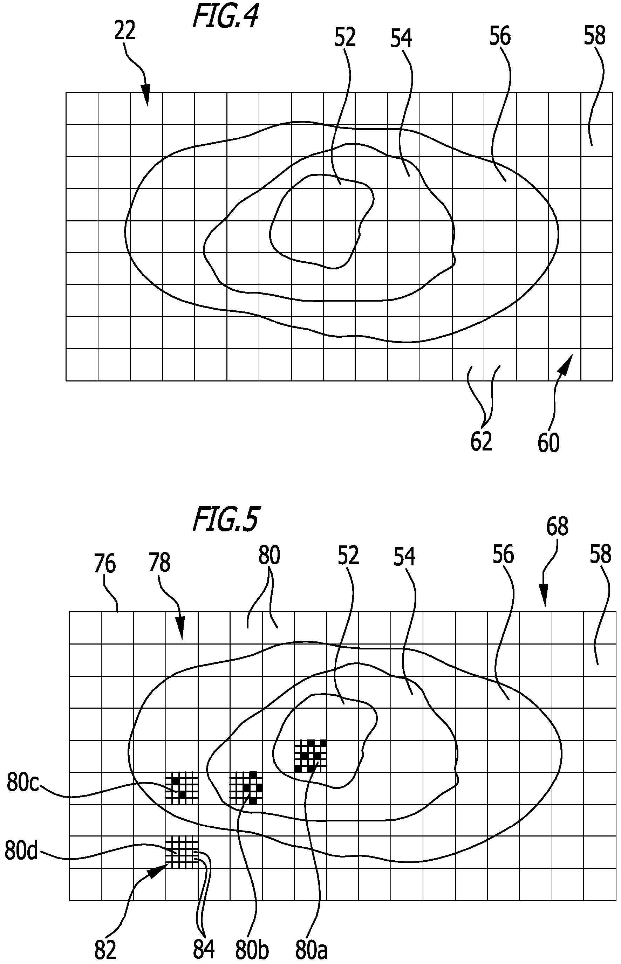

Das eingangs geschilderte Problem einer inhomogenen Intensitätsverteilung im Strahlungsfeld 13 zeigt sich beispielsweise dadurch, dass bei einer Messung der Strahlungsintensität in der Bauebene 22, beispielsweise mit einem Strahlungsdetektor wie zum Beispiel einer lichtempfindlichen Diode, das schematisch in Figur 4 dargestellte Intensitätsdiagramm erhalten wird.

Dem Intensitätsdiagramm lässt sich entnehmen, dass das Strahlungsfeld 13 der Strahlungsquelle 18, beispielsweise eine Leuchtdiode oder eine Laserdiode, typischerweise im Zentrum 52 die höchste Strahlungsintensität aufweist, in einem ersten Ring oder Bereich 54 um das Zentrum 52 eine etwas verringerte Strahlungsintensität, in einem zweiten Ring oder Bereich 56, welcher den ersten Ring 54 umgibt, eine nochmals abgeschwächte Strahlungsintensität sowie im Bereich 58 um den zweiten Ring 56 herum eine noch weiter abgeschwächte Strahlungsintensität. In der Praxis können weitaus mehr derartig abgestufte Ringe oder Bereiche erhalten werden, insbesondere abhängig von der Art und Form der Strahlungsquelle 18 und wie genau eine Abstufung gewünscht ist.

In das Intensitätsdiagramm der Figur 4 ist ein Pixelraster 60 eingezeichnet mit einer Mehrzahl identischer Kalibrierpixel 62. Insbesondere können die Kalibrierpixel 62 wie beschrieben mit einem einfachen Strahlungsdetektor sukzessive oder mit einem geeigneten zweidimensionalen Strahlungsdetektor, beispielsweise einem CCD-Chip, gleichzeitig ausgemessen werden, um so den Intensitätsverlauf zu erhalten.

Damit das herzustellende Objekt 12 beziehungsweise 12' homogen verfestigt wird, ist es wünschenswert, dass das Strahlungsfeld 13 keinen wie in Figur 4 dargestellten Intensitätsverlauf aufweist, sondern homogen ist. Mit anderen Worten ist das Ziel, dass alle Kalibrierpixel 62 mit derselben Intensität der Strahlung 14 beaufschlagt werden.

Da in der Praxis keine Strahlungsquelle 18 zur Verfügung steht, die einen wie gewünscht konstanten oder homogenen Intensitätsverlauf in der Bauebene 22 oder in einer zwischen der Strahlungsquelle 18 und der Bauebene 22 verlaufenden Kalibrierfläche 64 aufweist, wird bei den Vorrichtungen 10 und 10' zusätzlich eine Korrekturvorrichtung 66 eingesetzt zum Korrigieren einer inhomogenen Intensitätsverteilung des von der Strahlungsquelle 18 erzeugten Strahlungsfeldes 13.

Die Korrekturvorrichtung 66 umfasst eine Korrektur- oder Filtereinrichtung 68 zum Einbringen in einen Strahlengang 70 der Vorrichtungen 10 beziehungsweise 10' zwischen die Strahlungsquelle 18 und der Bauebene 22. Die Korrektur- oder Filtereinrichtung 68, die bei den Vorrichtungen 10 und 10' vorgesehen ist, weist einen Träger 72 auf, welcher eine Korrektur- oder Filterschicht 74 umfasst. Die Korrektur- oder Filterschicht 74 kann auf dem Träger 72 ausgebildet oder auf diesen aufgebracht sein.

Die Korrektur- oder Filterschicht 74 ist insbesondere ausgebildet zum mindestens teilweisen Absorbieren der Strahlung 14, vorzugsweise zum Absorbieren von Strahlung in einem Wellenlängenbereich von etwa 300 nm bis etwa 900 nm.

Der Träger 72 ist für die Strahlung 14 durchlässig oder im Wesentlichen durchlässig ausgebildet. Er ist beispielsweise in Form einer durchsichtigen Platte, beispielsweise einer Glasplatte, oder einer durchsichtigen Kunststofffolie 76 ausgebildet. Eine solche Kunststofffolie 76 ist schematisch in Figur 5 dargestellt. Die Kunststofffolie 76 ist gerastert und entsprechend dem Pixelraster 60 mit einem Pixelraster 78 überlagert. Das Pixelraster 78 entspricht dem Pixelraster, das den Soll-Schichtbilddaten entspricht, die mit der Abbildungsoptik 20 auf die Bauebene 22 abgebildet werden sollen. Das Pixelraster 78 umfasst eine Mehrzahl von Bildpixelx 80 identischer Größe.

Um die Inhomogenität im Intensitätsverlauf des Strahlungsfeldes 13 auszugleichen, werden die Bereiche 52, 54, 56 und 58 dem Pixelraster 78 überlagert. Damit nun in allen Bereichen 52, 54, 56 und 58 die jeweiligen Pixel 80 mit einer identischen Strahlungsintensität beaufschlagt werden, wird die Korrektur- oder Filterschicht 74 auf den Träger 72 so aufgebracht, dass im Bereich 52 am meisten Strahlung absorbiert wird, im Bereich 54 etwas weniger, im Bereich 56 noch etwas weniger und im Bereich 58 noch etwas weniger.

Ein Maximalwert der Intensitätsverteilung des Strahlungsfeldes 13 wird wie beschrieben im Zentrum 52 gemessen, ein Minimalwert der Intensitätsverteilung des Strahlungsfeldes 13 im Bereich 58.

Um eine homogene Intensitätsverteilung zu erhalten, wird bei der Korrektur- oder Filterschicht 74 ein Minimalabsorptionswert im Bereich 58 vorgesehen, ein Maximalabsorptionswert für die Strahlung 14 im Zentrum 52.

Die Korrektur- oder Filterschicht 74 kann beispielsweise derart ausgebildet werden, dass ihre Dicke in Abhängigkeit der Bereiche 52, 54, 56 oder 58 variiert, sie also umso dicker ist in denjenigen Bereichen, in denen die Intensität des Strahlungsfeldes 13 am größten ist.

Idealerweise wird die Korrektur- oder Filterschicht 74 im Bereich 58 mit dem Minimalwert der Intensitätsverteilung weggelassen oder weist dort einen minimalen Wert auf.

Alternativ zu unterschiedlichen Schichtdicken für die unterschiedlichen Bereiche 52, 54, 56 und 58 kann auch, wie in Figur 5 für die Pixel 80a, 80b, 80c und 80d schematisch dargestellt, jedes Bildpixel 80 mit einem Filterpixelraster 82 überlagert werden, wobei die Auflösung des Filterpixelrasters 82 vorzugsweise einem ganzzahligen Vielfachen der Auflösung des Pixelrasters 78 entspricht. Je feiner jedes Bildpixel 80 in Filterpixel 84 unterteilt ist, umso feiner kann eine Filtereigenschaft der Korrektur- oder Filterschicht 74 eingestellt werden.

In Figur 5 ist für das Bildpixel 80a im Zentrum 52, das mit dem Maximalwert der Intensitätsverteilung beaufschlagt wird, vorgesehen, sechs Filterpixel 84 beispielsweise zu schwärzen, um eine Transmission der Strahlung 14 zu unterbinden.

Im Bereich 54 ist die Intensität der Strahlung 14 etwas geringer als im Zentrum 52. Daher muss im ersten Ring 54 nicht so viel von der Strahlung 14 absorbiert werden, damit die Intensität der Strahlung 14 nach Passieren der Korrektur- oder Filtereinrichtung 68 für alle Bildpixel 80 dieselbe Intensität aufweist. Beim Pixel 80b sind daher nur vier Filterpixel 84 geschwärzt. Entsprechend sind beim Bildpixel 80c im zweiten Ring 56 beziehungsweise Bereich 56 zwei Filterpixel 84 geschwärzt, beim Bildpixel 80d im Bereich 58 gar kein Filterpixel 84. Dies bedeutet, dass die Strahlung 14 das Bildpixel 80d praktisch ungehindert passieren kann.

Aus Gründen der Übersichtlichkeit sind in Figur 5 nicht alle Bildpixel 80 mit dem Filterpixelraster 82 versehen. Dies kann jedoch für jedes Bildpixel 80 entsprechend vorgenommen werden. Auf diese Weise ist es möglich, beispielsweise auf eine transparente Kunststofffolie oder eine Glasplatte ein entsprechendes schwarz-weiß Bitmap aufzudrucken, um so eine aus Filterpixeln 84 zusammengesetzte Korrektur- oder Filterschicht 74 auszubilden. Die Korrektur- oder Filterschicht besteht somit aus Filterpixeln, die entweder den Bit-Wert 0 oder den Bit-Wert 1 aufweisen. Beispielsweise kann der Bit-Wert 0 einer Schwärzung des Filterpixels 84 entsprechen, der Bit-Wert 1 einer Nichtschwärzung des Filterpixels 84.

In der beschriebenen Weise können die Vorrichtung 10 und 10' zunächst wie üblich aufgebaut werden. Dann kann mit der Strahlungsquelle 18 die Bauebene 22 vollflächig bestrahlt werden, um das Strahlungsfeld 13 zu vermessen. Dies kann beispielsweise direkt in der Bauebene 22 erfolgen, sodass die Kalibrierfläche 64 eine Kalibrierebene 86 definiert, oder in einer beliebigen anderen gekrümmten oder ebenen Kalibrierfläche 64, indem die Kalibrierfläche 64 entweder flächig mit einem zweidimensionalen Strahlungsdetektor oder mit einem eindimensionalen Strahlungsdetektor gerastert vermessen wird.

Auf Basis des gemessenen Intensitätsverlaufs des Strahlungsfeldes 13, wie schematisch in Figur 4 dargestellt, kann dann die korrespondierende Korrektur- oder Filterschicht 74 hergestellt werden, die dann genau zur vermessenen Vorrichtung 10 mit der Strahlungsquelle 18 passt.

Nach Herstellung der Korrektur- oder Filtereinrichtung 68 kann diese in den Strahlengang 70 eingebracht werden. Vorzugsweise erfolgt dies dort, wo die Vermessung des Strahlungsfeldes 13 erfolgte. Wird die Korrektur- oder Filtereinrichtung 68 an einer anderen Stelle im Strahlengang 70 eingebracht, muss gegebenenfalls noch eine Größenanpassung der Korrektur- oder Filtereinrichtung 68 quer zur Strahlungsrichtung vorgenommen werden.

Die Korrektur- oder Filtereinrichtung 68 kann beispielweise in einer Halterung 88 gehalten werden. Insbesondere kann am Boden 50 eine Halterung 90 vorgesehen werden, die eine Korrektur- oder Filtereinrichtung 68 aufnehmen kann.

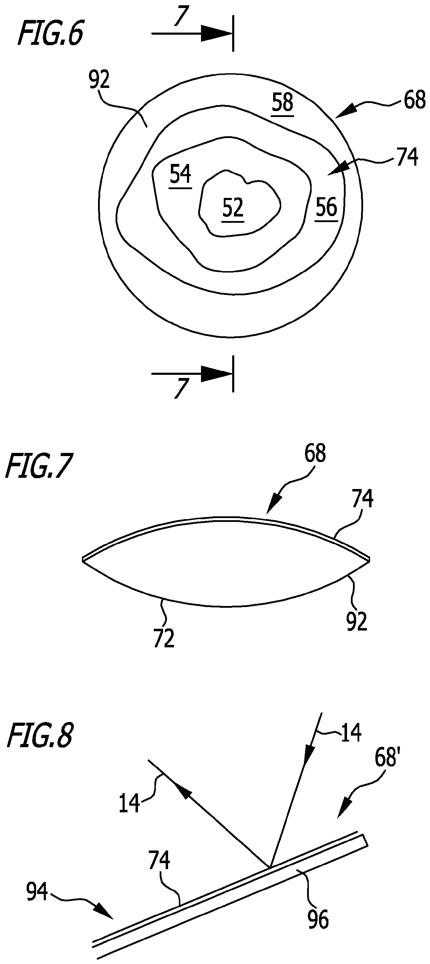

Umfasst die Abbildungsoptik 20 beispielsweise eine Linse 92, so kann auch eine Korrektur- oder Filterschicht 74 direkt auf eine Oberfläche derselben aufgebracht werden. Die Linse 92 bildet dann den Träger 72 und die Linse 92 mit der Korrektur- oder Filterschicht 74 zusammen die Korrektur- oder Filtereinrichtung 68. Dies ist schematisch in den Figuren 6 und 7 dargestellt.

Ähnlich wie die beispielhaft in Figur 5 dargestellte Kunststofffolie kann auch die Linse 92 gerastert bedruckt werden, um die Korrektur- oder Filtereinrichtung 68 zu bilden.

In Figur 8 ist schematisch ein weiteres optisches Element 94 dargestellt, und zwar in Form eines Spiegels 96, mit dem die Strahlung 14 umgelenkt werden kann durch Reflexion.

Ähnlich wie bei der Linse 92 oder bei der Kunststofffolie 76 kann auf dem Spiegel 96 eine Korrektur- oder Filterschicht 74 aufgebracht sein, beispielsweise durch Aufdrucken, die an den gemessenen Intensitätsverlauf des Strahlungsfeldes 13 der Strahlungsquelle 18 angepasst ist. Trifft die Strahlung 14 auf den beschichteten Spiegel 96 auf, weist das Strahlungsfeld 13 nach Reflexion am Spiegel 96 eine homogene Intensitätsverteilung auf. Das Strahlungsfeld 13 weist somit nach Passieren des optischen Elements 94 wie oben für die Kunststofffolie 76 beschrieben auch für den Spiegel 96 für jedes Bildpixel 80 dieselbe Intensität auf.

Wie erläutert ist für die Ausbildung der Korrektur- oder Filtereinrichtung 68 mindestens eine einmalige Vermessung der Vorrichtung 10 beziehungsweise des Strahlungsfeldes 13 der Strahlungsquelle 18 erforderlich. Insbesondere bei Strahlungsquellen 18 mit einer nur geringen Änderung der Strahlungsintensität im Langzeitverlauf kann so auf einfache und kostengünstige Weise eine Homogenisierung der Strahlungsintensität der von der Strahlungsquelle 18 emittierten Strahlung 14 erreicht werden.

Sollte sich nach einer bestimmten Zeit beispielsweise durch Alterung oder anderweitige Änderung der Strahlungsquelle 18 aufgrund ihres Betriebs eine Änderung im Intensitätsverlauf einstellen, kann die beschriebene Herstellung der Korrekturvorrichtung 66 nochmals vorgenommen werden. Ein Austausch der Korrektur- oder Filtereinrichtung 68 ist besonders einfach, wenn eine wie oben beschriebene Kunststofffolie 76 in eine für diese vorgesehene Halterung 88 oder 90 eingesetzt wird.

### Bezugszeichenliste

- 10, 10': Vorrichtung
- 12, 12': Objekt
- 13: Strahlungsfeld
- 14: Strahlung
- 16: Material
- 18: Strahlungsquelle
- 20: Abbildungsoptik
- 22: Bild-/Bauebene
- 24: Maskeneinheit
- 26: Belichtungsmaskenerzeugungseinrichtung
- 28: Belichtungsmaske
- 30: 2-Bit-Bitmap
- 32: Bit-Wert
- 34: Bit-Wert
- 36: Speichereinrichtung
- 38: Computer
- 40, 40': Trägersystem
- 42: Trägerplatte
- 44, 44': Behälter
- 46: Antriebseinheit
- 48: Platte
- 50: Boden
- 52: Zentrum/Bereich
- 54: erster Ring/Bereich
- 56: zweiter Ring/Bereich
- 58: Bereich
- 60: Pixelraster
- 62: Kalibrierpixel
- 64: Kalibrierfläche
- 66: Korrekturvorrichtung
- 68: Korrektur- oder Filtereinrichtung
- 70: Strahlengang
- 72: Träger
- 74: Korrektur- oder Filterschicht
- 76: Kunststofffolie
- 78: Pixelraster
- 80: Bildpixel
- 82: Filterpixelraster
- 84: Filterpixel
- 86: Kalibrierebene
- 88: Halterung
- 90: Halterung
- 92: Linse
- 94: optisches Element
- 96: Spiegel

## Patentansprüche

1. System umfassend eine Strahlungsquelle (18) und eine Vorrichtung (66) zur Korrektur einer inhomogenen Intensitätsverteilung eines von der Strahlungsquelle (18) erzeugten Strahlungsfeldes (13) für eine Vorrichtung (10) zum Herstellen dreidimensionaler Objekte (12) durch schichtweises Verfestigen eines unter Einwirkung von Strahlung (14) verfestigbaren Materials (16) in einer Bauebene (22), welche Vorrichtung eine Korrektur- oder Filtereinrichtung (68) umfasst zum Einbringen in einen Strahlengang (70) einer Vorrichtung zum Herstellen dreidimensionaler Objekte (12) durch schichtweises Verfestigen eines unter Einwirkung von Strahlung (14) verfestigbaren Materials (16) zwischen der Strahlungsquelle (18) und der Bauebene (22), wobei eine Intensitätsverteilung des Strahlungsfeldes (13) in einer Kalibrierfläche (64) zwischen der Strahlungsquelle (18) und der Bauebene (22) oder in der Bauebene (22) gemessen oder berechnet und eine Korrektur- oder Filtereinrichtung (68) zum Einbringen in den Strahlengang (70) ausgebildet ist in Abhängigkeit der Intensitätsverteilung des Strahlungsfeldes (13) in der Kalibrierfläche (64) derart, dass die Intensitätsverteilung des Strahlungsfeldes (13) in der Bauebene (22) nach dem Passieren der Korrektur- oder Filtereinrichtung (68) homogen ist, wobei ein Absorptions- oder Reflexionsverhalten der Korrektur- oder Filtereinrichtung (68) zeitlich konstant ist, wobei die Korrektur- oder Filtereinrichtung (68) einen Träger (72) und mindestens eine auf dem Träger (72) ausgebildete oder aufgebrachte Korrektur- oder Filterschicht (74) umfasst und wobei die Korrektur- oder Filterschicht (74) ausgebildet ist in Abhängigkeit der Intensitätsverteilung des Strahlungsfeldes (13) in der Kalibrierfläche (64) derart, dass die Intensitätsverteilung des Strahlungsfeldes (13) in der Bauebene (22) nach dem Passieren der Korrektur- oder Filtereinrichtung (68) homogen ist, **dadurch gekennzeichnet, dass** die Korrektur- oder Filterschicht (74) mindestens zwei Korrektur- oder Filterschichtbereiche (52, 54, 56, 58) aufweist, welche einen minimalen und einen maximalen Strahlungsschwächungswert aufweisen, dass eine Differenz zwischen dem minimalen und dem maximalen Strahlungsschwächungswert einer Differenz zwischen einer minimalen und einer maximalen Strahlungsintensität des Strahlungsfeldes (13) in einer Kalibrierfläche (64) zwischen der Strahlungsquelle (18) und der Bauebene (22) oder in der Bauebene (22) entspricht, dass die Kalibrierfläche (64) gerastert ist und eine Mehrzahl von Kalibrierflächenpixeln (62) definiert, dass die Korrektur- oder Filterschicht (74) eine der Mehrzahl von Kalibrierflächenpixeln (62) entsprechende Mehrzahl von Korrektur- oder Filterschichtpixeln (84) umfasst und dass ein Strahlungsschwächungswert jedes Korrektur- oder Filterschichtpixels (84) an die Intensität der auf dieses Korrektur- oder Filterschichtpixel (84) auftreffenden Strahlung (14) der Strahlungsquelle (18) angepasst ist derart, dass die Intensität des Strahlungsfeldes (13) nach dem Passieren des Korrektur- oder Filterschichtpixels (84) für alle Korrektur- oder Filterschichtpixel (84) identisch oder im Wesentlichen identisch ist.

2. System nach Anspruch 1, **dadurch gekennzeichnet, dass** die Korrektur- oder Filterschicht (74) ausgebildet ist zum mindestens teilweisen Absorbieren von Strahlung (14) oder zum mindestens teilweisen Ablenken von Strahlung (14) aus dem Strahlungsfeld (13), welche Strahlung (14) mit der Strahlungsquelle (18) erzeugt wird.

3. System nach einem der voranstehenden Ansprüche, **dadurch gekennzeichnet, dass** die Korrektur- oder Filterschicht (74) ausgebildet ist zum Absorbieren oder Ablenken von Strahlung (14) in einem Wellenlängenbereich von etwa 200 nm bis etwa 900 nm, insbesondere in einem Bereich von etwa 350 nm bis etwa 550 nm.

4. System nach einem der voranstehenden Ansprüche, **dadurch gekennzeichnet, dass** der Träger (72) mindestens teilweise für Strahlung (14) durchlässig oder mindestens teilweise Strahlung (14) reflektierend ausgebildet ist.

5. System nach einem der voranstehenden Ansprüche, **dadurch gekennzeichnet, dass**
a) der Träger (72) in Form einer optischen Linse (92), eines optischen Spiegels (96), einer Glasplatte, einer Kunststoffplatte oder einer Kunststofffolie (76) oder eines transparenten oder reflektierenden Materials ausgebildet ist und/oder
b) dass die Korrektur- oder Filterschicht (74) auf den Träger (72) aufgedruckt ist.

6. Verfahren zum Herstellen einer Vorrichtung zur Korrektur einer inhomogenen Intensitätsverteilung eines von einer Strahlungsquelle (18) erzeugten Strahlungsfeldes (13) einer Vorrichtung (10) zum Herstellen dreidimensionaler Objekte (12) durch schichtweises Verfestigen eines unter Einwirkung von Strahlung (14) verfestigbaren Materials (16) in einer Bauebene (22), wobei eine Intensitätsverteilung des Strahlungsfeldes (13) in einer Kalibrierfläche (64) zwischen der Strahlungsquelle (18) und der Bauebene (22) oder in der Bauebene (22) gemessen oder berechnet und eine Korrektur- oder Filtereinrichtung (68) zum Einbringen in den Strahlengang (70) ausgebildet wird in Abhängigkeit der Intensitätsverteilung des Strahlungsfeldes (13) in der Kalibrierfläche (64) derart, dass die Intensitätsverteilung des Strahlungsfeldes (13) in der Bauebene (22) nach dem Passieren der Korrektur- oder Filtereinrichtung (68) homogen ist, wobei ein Absorptions- oder Reflexionsverhalten der Korrektur- oder Filtereinrichtung (68) zeitlich konstant vorgesehen wird, wobei zur Ausbildung der Korrektur- oder Filtereinrichtung (68) ein Träger (72) bereitgestellt wird, wobei auf dem Träger (72) eine Korrektur- oder Filterschicht (74) ausgebildet oder aufgebracht wird und wobei die Korrektur- oder Filterschicht (74) ausgebildet wird in Abhängigkeit der Intensitätsverteilung des Strahlungsfeldes (13) in der Kalibrierfläche (64) derart, dass die Intensitätsverteilung des Strahlungsfeldes (13) in der Bauebene (22) nach dem Passieren der Korrektur- oder Filtereinrichtung (68) homogen ist, **dadurch gekennzeichnet, dass** ein Minimalwert und ein Maximalwert der Intensitätsverteilung der Strahlung (14) in der Kalibrierfläche (64) gemessen werden und dass derjenige Flächenbereich (52, 54, 56, 58) der Korrektur- oder Filterschicht (74), zu welchem der Minimalwert der Intensitätsverteilung in der Kalibrierfläche (64) korrespondiert, mit einem Minimalabsorptionswert für die Strahlung (14) ausgebildet wird, dass derjenige Flächenbereich (52, 54, 56, 58) der Korrektur- oder Filterschicht (74), zu welchem der Maximalwert der Intensitätsverteilung korrespondiert, mit einem Maximalabsorptionswert der Strahlung (14) ausgebildet wird, dass die Kalibrierfläche (64) gerastert wird und eine Mehrzahl von Kalibrierflächenpixeln (62) definiert, dass die Korrektur- oder Filterschicht (74) eine der Mehrzahl von Kalibrierflächenpixeln (62) entsprechende Mehrzahl von Korrektur- oder Filterschichtpixeln (84) umfasst und dass ein Strahlungsschwächungswert jedes Korrektur- oder Filterschichtpixels (84) an die Intensität der auf dieses Korrektur- oder Filterschichtpixel (84) auftreffenden Strahlung der Strahlungsquelle (18) angepasst wird derart, dass die Intensität der Strahlung (14) nach dem Passieren des Korrektur- oder Filterschichtpixels (84) für alle Korrektur- oder Filterschichtpixel (84) identisch ist.

7. Verfahren nach Anspruch 6, **dadurch gekennzeichnet, dass** die Intensitätsverteilung der Strahlungsquelle (18) in einer Kalibrierfläche (64) gemessen wird, welche eine Kalibrierebene (86) definiert.

8. Verfahren nach Anspruch 6 oder 7, **dadurch gekennzeichnet, dass** als Träger eine optische Linse (92), ein optischer Spiegel (96), eine Glasplatte, eine Kunststoffplatte oder eine Kunststofffolie (76) bereitgestellt wird.

9. Verfahren nach einem der Ansprüche 6 bis 8, **dadurch gekennzeichnet, dass** der Träger (72) zur Ausbildung der Korrektur- oder Filterschicht (74) bedruckt wird, insbesondere gerastert bedruckt wird.

10. Verfahren nach Anspruch 8 oder 9, **dadurch gekennzeichnet, dass** die Korrektur- oder Filterschicht (74) derart ausgebildet wird, dass eine Differenz zwischen dem Maximalwert und dem Minimalwert der Intensitätsverteilung des Strahlungsfeldes (13) einer Differenz zwischen dem Maximalabsorptionswert und dem Minimalabsorptionswert entspricht.

11. Verfahren zum Herstellen eines dreidimensionalen Objekts (12) durch schichtweises Verfestigen eines unter Einwirkung von Strahlung (14) verfestigbaren Materials (16), wobei die Strahlung (14) mit einer optischen Abbildungseinrichtung (20) in eine Bauebene (22) abgebildet wird zum sukzessiven Ausbilden fester Objektschichten in der Bauebene (22), bei welchem Verfahren Soll-Schichtbilddaten für jede in der Bauebene (22) zu verfestigende Objektschicht bereitgestellt werden, wobei eine Vorrichtung (66) zur Korrektur einer inhomogen Intensitätsverteilung eines durch die Strahlung (14) definierten Strahlungsfeldes (13) bereitgestellt und in einen Strahlengang (70) zwischen eine die Strahlung (14) erzeugende Strahlungsquelle (18) und die Bauebene (22) eingebracht wird und wobei zum Bestrahlen der Bauebene (22) ein Strahlungsfeld (13) entsprechend den Soll-Schichtbilddaten erzeugt wird, **dadurch gekennzeichnet, dass** ein System in Form eines Systems nach einem der Ansprüche 1 bis 5 bereitgestellt wird und dass die Vorrichtung (66) zur Korrektur einer inhomogen Intensitätsverteilung der Strahlung (14) in einen Strahlengang (70) zwischen die die Strahlung (14) erzeugende Strahlungsquelle (18) und die Bauebene (22) eingebracht wird.

12. Vorrichtung (10) zum Herstellen eines dreidimensionalen Objekts (12) durch schichtweises Verfestigen eines unter Einwirkung von Strahlung (14) verfestigbaren Materials (16), mit einer Strahlungsquelle (18) zum Erzeugen der Strahlung (14) und einer optischen Abbildungseinrichtung (20) zum Abbilden eines von der Strahlungsquelle (18) erzeugten Strahlungsfeldes (13) in eine Bauebene (22), **gekennzeichnet durch** ein System nach einem der Ansprüche 1 bis 5.

13. Vorrichtung nach Anspruch 12, **dadurch gekennzeichnet, dass** die Strahlungsquelle (18) mindestens eine Leuchtdiode oder mindestens eine Laserdiode umfasst.

14. Verwendung einer Vorrichtung (10) zum Herstellen eines dreidimensionalen Objekts (12) durch schichtweises Verfestigen eines unter Einwirkung von Strahlung (14) verfestigbaren Materials (16) nach Anspruch 12 oder 13 zur Durchführung eines Verfahrens zum Herstellen eines dreidimensionalen Objekts (12) durch schichtweises Verfestigen eines unter Einwirkung von Strahlung (14) verfestigbaren Materials (16) nach Anspruch 11.

## Claims

1. System comprising a radiation source (18) and an apparatus (66) for correcting an inhomogeneous intensity distribution of a radiation field (13) generated by the radiation source (18) for an apparatus (10) for manufacturing three-dimensional objects (12) by solidifying in layers a material (16) that is solidifiable under the effect of radiation (14) in a building plane (22), which apparatus comprises a correction or filter device (68) for introduction into a radiation path (70) of an apparatus for manufacturing three-dimensional objects (12) by solidifying in layers a material (16) that is solidifiable under the effect of radiation (14) between the radiation source (18) and the building plane (22), wherein an intensity distribution of the radiation field (13) is measured or calculated in a calibration surface (64) between the radiation source (18) and the building plane (22) or in the building plane (22) and a correction or filter device (68) is configured for introduction into the radiation path (70) in dependence on the intensity distribution of the radiation field (13) in the calibration surface (64) in such a way that the intensity distribution of the radiation field (13) in the building plane (22) is homogeneous after passing through the correction or filter device (68), wherein an absorption or reflection behavior of the correction or filter device (68) is constant over time, wherein the correction or filter device (68) comprises a substrate (72) and at least one correction or filter layer (74) formed on or applied to the substrate (72), and wherein the correction or filter layer (74) is formed in dependence on the intensity distribution of the radiation field (13) in the calibration surface (64) in such a way that the intensity distribution of the radiation field (13) in the building plane (22) is homogeneous after passing through the correction or filter device (68), **characterized in that** the correction or filter layer (74) has at least two correction or filter layer regions (52, 54, 56, 58), which have a minimum and a maximum radiation attenuation value, **in that** a difference between the minimum and the maximum radiation attenuation value corresponds to a difference between a minimum and a maximum radiation intensity of the radiation field (13) in a calibration surface (64) between the radiation source (18) and the building plane (22) or in the building plane (22), **in that** the calibration surface (64) is rasterized and defines a plurality of calibration surface pixels (62), **in that** the correction or filter layer (74) comprises a plurality of correction or filter layer pixels (84) corresponding to the plurality of calibration layer pixels (62), and **in that** a radiation attenuation value of each correction or filter layer pixel (84) is adapted to the intensity of the radiation (14) of the radiation source (18) impinging on said correction or filter layer pixel (84) in such a way that the intensity of the radiation field (13) is identical or substantially identical for all correction or filter layer pixels (84) after passing through the correction or filter layer pixel (84).

2. System in accordance with Claim 1, **characterized in that** the correction or filter layer (74) is configured to at least partially absorb radiation (14) or to at least partially deflect radiation (14) from the radiation field (13), which radiation (14) is generated with the radiation source (18).

3. System in accordance with any one of the preceding Claims, **characterized in that** the correction or filter layer (74) is configured to absorb or deflect radiation (14) in a wavelength range of about 200 nm to about 900 nm, in particular in a range of about 350 nm to about 550 nm.

4. System in accordance with any one of the preceding Claims, **characterized in that** the substrate (72) is configured to be at least partially transmissive to radiation (14) or at least partially reflective to radiation (14).

5. System in accordance with any one of the preceding Claims, **characterized in that**
a) the substrate (72) is configured in the form of an optical lens (92), an optical mirror (96), a glass plate, a plastic plate, or a plastic film (76) or a transparent or reflective material
and/or
b) **in that** the correction or filter layer (74) is printed onto the substrate (72).

6. Method for producing an apparatus for correcting an inhomogeneous intensity distribution of a radiation field (13), generated by a radiation source (18), of an apparatus (10) for manufacturing three-dimensional objects (12) by solidifying in layers a material (16) that is solidifiable under the effect of radiation (14) in a building plane (22), wherein an intensity distribution of the radiation field (13) is measured or calculated in a calibration surface (64) between the radiation source (18) and the building plane (22) or in the building plane (22) and a correction or filter device (68) is configured for introduction into the radiation path (70) in dependence on the intensity distribution of the radiation field (13) in the calibration surface (64) in such a way that the intensity distribution of the radiation field (13) in the building plane (22) is homogenous after passing through the correction or filter device (68), wherein an absorption or reflection behavior of the correction or filter device (68) is provided to be constant over time, wherein a substrate (72) is provided for forming the correction or filter device (68), wherein a correction or filter layer (74) is formed on or applied to the substrate (72), and wherein the correction or filter layer (74) is formed in dependence on the intensity distribution of the radiation field (13) in the calibration surface (64) in such a way that the intensity distribution of the radiation field (13) in the building plane (22) is homogeneous after passing through the correction or filter device (68), **characterized in that** a minimum value and a maximum value of the intensity distribution of the radiation (14) is measured in the calibration surface (64) and **in that** that surface region (52, 54, 56, 58) of the correction or filter layer (74) to which the minimum value of the intensity distribution in the calibration surface (64) corresponds is configured with a minimum absorption value for the radiation (14), **in that** that surface region (52, 54, 56, 58) of the correction or filter layer (74) to which the maximum value of the intensity distribution corresponds is configured with a maximum absorption value of the radiation (14), **in that** the calibration surface (64) is rasterized and defines a plurality of calibration surface pixels (62), **in that** the correction or filter layer (74) comprises a plurality of correction or filter layer pixels (84) corresponding to the plurality of calibration surface pixels (62), and **in that** a radiation attenuation value of each correction or filter layer pixel (84) is adapted to the intensity of the radiation of the radiation source (18) impinging on said correction or filter layer pixel (84) in such a way that the intensity of the radiation (14) is identical for all correction or filter layer pixels (84) after passing through the correction or filter layer pixels (84).

7. Method in accordance with Claim 6, **characterized in that** the intensity distribution of the radiation source (18) is measured in a calibration surface (64), which defines a calibration plane (86).

8. Method in accordance with Claim 6 or 7, **characterized in that** an optical lens (92), an optical mirror (96), a glass plate, a plastic plate, or a plastic film (76) is provided as a substrate.

9. Method in accordance with any one of Claims 6 to 8, **characterized in that** the substrate (72) is printed, in particular printed in a rasterized manner, for forming the correction or filter layer (74).

10. Method in accordance with Claim 8 or 9, **characterized in that** the correction or filter layer (74) is configured in such a way that a difference between the maximum value and the minimum value of the intensity distribution of the radiation field (13) corresponds to a difference between the maximum absorption value and the minimum absorption value.

11. Method for manufacturing a three-dimensional object (12) by solidifying in layers a material (16) that is solidifiable under the effect of radiation (14), wherein the radiation (14) is imaged with an optical imaging device (20) into a building plane (22) for successively forming solid object layers in the building plane (22), in which method desired layer image data are provided for each object layer to be solidified in the building plane (22), wherein an apparatus (66) for correcting an inhomogeneous intensity distribution of a radiation field (13) defined by the radiation (14) is provided and introduced into a radiation path (70) between a radiation source (18) generating the radiation (14) and the building plane (22), and wherein a radiation field (13) corresponding to the desired layer image data is generated for irradiating the building plane (22), **characterized in that** a system in the form of a system in accordance with any one of Claims 1 to 5 is provided, and **in that** the apparatus (66) is introduced into a radiation path (70) between the radiation source (18) generating the radiation (14) and the building plane (22) for correcting an inhomogeneous intensity distribution of the radiation (14).

12. Apparatus (10) for manufacturing a three-dimensional object (12) by solidifying in layers a material (16) that is solidifiable under the effect of radiation (14), having a radiation source (18) for generating the radiation (14) and an optical imaging device (20) for imaging a radiation field (13) generated by the radiation source (18) into a building plane (22), **characterized by** a system in accordance with any one of Claims 1 to 5.

13. Apparatus in accordance with Claim 12, **characterized in that** the radiation source (18) comprises at least one light-emitting diode or at least one laser diode.

14. Use of an apparatus (10) for manufacturing a three-dimensional object (12) by solidifying in layers a material (16) that is solidifiable under the effect of radiation (14) in accordance with Claim 12 or 13 for performing a method for manufacturing a three-dimensional object (12) by solidifying in layers a material (16) that is solidifiable under the effect of radiation (14) in accordance with Claim 11.

## Revendications

1. Système comprenant une source de rayonnement (18) et un dispositif (66) pour corriger une distribution d'intensité non homogène d'un champ de rayonnement (13) généré par la source de rayonnement (18) pour un dispositif (10) pour produire des objets tridimensionnels (12) par solidification par couches d'un matériau (16) solidifiable sous l'action d'un rayonnement (14) dans un plan de construction (22), lequel dispositif comprend un appareil de correction ou de filtrage (68) pour l'introduction dans un trajet de rayonnement (70) d'un dispositif pour produire des objets tridimensionnels (12) par solidification par couches d'un matériau (16) solidifiable sous l'action d'un rayonnement (14) entre la source de rayonnement (18) et le plan de construction (22), où une distribution d'intensité du champ de rayonnement (13) dans une surface d'étalonnage (64) entre la source de rayonnement (18) et le plan de construction (22) ou dans le plan de construction (22) est mesurée ou calculée et un appareil de correction ou de filtrage (68) est formé pour l'introduction dans le trajet de rayonnement (70) en fonction de la distribution d'intensité du champ de rayonnement (13) dans la surface d'étalonnage (64) de telle sorte que la distribution d'intensité du champ de rayonnement (13) dans le plan de construction (22) est homogène après le franchissement de l'appareil de correction ou de filtrage (68), où un comportement d'absorption ou de réflexion de l'appareil de correction ou de filtrage (68) est constant dans le temps, où l'appareil de correction ou de filtrage (68) comprend un support (72) et au moins une couche de correction ou de filtrage (74) formée ou appliquée sur le support (72) et où la couche de correction ou de filtrage (74) est formée en fonction de la distribution d'intensité du champ de rayonnement (13) dans la surface d'étalonnage (64) de telle sorte que la distribution d'intensité du champ de rayonnement (13) dans le plan de construction (22) est homogène après le franchissement de l'appareil de correction ou de filtrage (68), **caractérisé en ce que** la couche de correction ou de filtrage (74) présente au moins deux domaines de couche de correction ou de filtrage (52, 54, 56, 58) qui présentent une valeur d'atténuation de rayonnement minimale et une valeur d'atténuation de rayonnement maximale, **en ce qu'**une différence entre la valeur d'atténuation de rayonnement minimale et la valeur d'atténuation de rayonnement maximale correspond à une différence entre une intensité de rayonnement minimale et une intensité de rayonnement maximale du champ de rayonnement (13) dans une surface d'étalonnage (64) entre la source de rayonnement (18) et le plan de construction (22) ou dans le plan de construction (22), **en ce que** la surface d'étalonnage (64) est tramée et définit une pluralité de pixels de surface d'étalonnage (62), **en ce que** la couche de correction ou de filtrage (74) comprend une pluralité de pixels de couche de correction ou de filtrage (84) correspondant à la pluralité de pixels de surface d'étalonnage (62) et **en ce qu'**une valeur d'atténuation de rayonnement de chaque pixel de couche de correction ou de filtrage (84) est adaptée à l'intensité du rayonnement (14) de la source de rayonnement (18) frappant ce pixel de couche de correction ou de filtrage (84) de telle sorte que l'intensité du champ de rayonnement (13) après le franchissement du pixel de couche de correction ou de filtrage (84) est identique ou sensiblement identique pour tous les pixels de couche de correction ou de filtrage (84).

2. Système selon la revendication 1, **caractérisé en ce que** la couche de correction ou de filtrage (74) est formée pour l'absorption au moins partielle du rayonnement (14) ou pour la déviation au moins partielle du rayonnement (14) du champ de rayonnement (13), lequel rayonnement (14) est généré avec la source de rayonnement (18).

3. Système selon l'une des revendications précédentes, **caractérisé en ce que** la couche de correction ou de filtrage (74) est formée pour absorber ou dévier le rayonnement (14) dans un domaine de longueurs d'onde d'environ 200 nm à environ 900 nm, en particulier dans un domaine d'environ 350 nm à environ 550 nm.

4. Système selon l'une des revendications précédentes, **caractérisé en ce que** le support (72) est formé au moins partiellement transparent pour le rayonnement (14) ou au moins partiellement réfléchissant pour le rayonnement (14).

5. Système selon l'une des revendications précédentes, **caractérisé en ce que**
a) le support (72) est formé sous forme d'une lentille optique (92), d'un miroir optique (96), d'une plaque de verre, d'une plaque de matière plastique ou d'un film de matière plastique (76) ou d'un matériau transparent ou réfléchissant et/ou
b) **en ce que** la couche de correction ou de filtrage (74) est imprimée sur le support (72).

6. Procédé pour produire un appareil de correction d'une distribution d'intensité non homogène d'un champ de rayonnement (13) généré par une source de rayonnement (18) d'un dispositif (10) pour produire des objets tridimensionnels (12) par solidification par couches d'un matériau (16) solidifiable sous l'action d'un rayonnement (14) dans un plan de construction (22), où une distribution d'intensité du champ de rayonnement (13) dans une surface d'étalonnage (64) entre la source de rayonnement (18) et le plan de construction (22) ou dans le plan de construction (22) est mesurée ou calculée et un appareil de correction ou de filtrage (68) est formé pour l'introduction dans le trajet de rayonnement (70) en fonction de la distribution d'intensité du champ de rayonnement (13) dans la surface d'étalonnage (64) de telle sorte que la distribution d'intensité du champ de rayonnement (13) dans le plan de construction (22) après le franchissement de l'appareil de correction ou de filtrage (68) est homogène, où un comportement d'absorption ou de réflexion de l'appareil de correction ou de filtrage (68) est prévu constant dans le temps, où un support (72) est prévu pour former l'appareil de correction ou de filtrage (68), où une couche de correction ou de filtrage (74) est formée ou appliquée sur le support (72) et où la couche de correction ou de filtrage (74) est formée en fonction de la distribution d'intensité du champ de rayonnement (13) dans la surface d'étalonnage (64) de telle sorte que la distribution d'intensité du champ de rayonnement (13) dans le plan de construction (22) est homogène après le franchissement de l'appareil de correction ou de filtrage (68), **caractérisé en ce qu'**une valeur minimale et une valeur maximale de la distribution d'intensité du rayonnement (14) dans la surface d'étalonnage (64) sont mesurées et que le domaine de surface (52, 54, 56, 58) de la couche de correction ou de filtrage (74) auquel correspond la valeur minimale de la distribution d'intensité dans la surface d'étalonnage (64) est formé avec une valeur d'absorption minimale pour le rayonnement (14), **en ce que** le domaine de surface (52, 54, 56, 58) de la couche de correction ou de filtrage (74) auquel correspond la valeur maximale de la distribution d'intensité est formé avec une valeur d'absorption maximale du rayonnement (14), **en ce que** la surface d'étalonnage (64) est tramée et définit une pluralité de pixels de surface d'étalonnage (62), **en ce que** la couche de correction ou de filtrage (74) comprend une pluralité de pixels de couche de correction ou de filtrage (84) correspondant à la pluralité de pixels de surface d'étalonnage (62) et **en ce qu'**une valeur d'atténuation de rayonnement de chaque pixel de couche de correction ou de filtrage (84) est adaptée à l'intensité du rayonnement de la source de rayonnement (18) qui frappe ce pixel de couche de correction ou de filtrage (84) de telle sorte que l'intensité du rayonnement (14) après le franchissement du pixel de couche de correction ou de filtrage (84) est identique pour tous les pixels de couche de correction ou de filtrage (84).

7. Procédé selon la revendication 6, **caractérisé en ce que** la distribution d'intensité de la source de rayonnement (18) est mesurée dans une surface d'étalonnage (64) qui définit un plan d'étalonnage (86).

8. Procédé selon la revendication 6 ou 7, **caractérisé en ce qu'**une lentille optique (92), un miroir optique (96), une plaque de verre, une plaque de matière plastique ou un film de matière plastique (76) est prévu comme support.

9. Procédé selon l'une des revendications 6 à 8, **caractérisé en ce que** le support (72) est imprimé, en particulier est imprimé de manière tramée, pour former la couche de correction ou de filtrage (74).

10. Procédé selon la revendication 8 ou 9, **caractérisé en ce que** la couche de correction ou de filtrage (74) est formée de telle sorte qu'une différence entre la valeur maximale et la valeur minimale de la distribution d'intensité du champ de rayonnement (13) correspond à une différence entre la valeur d'absorption maximale et la valeur d'absorption minimale.

11. Procédé pour produire un objet tridimensionnel (12) par solidification par couches d'un matériau (16) solidifiable sous l'action d'un rayonnement (14), où le rayonnement (14) est soumis à une imagerie avec un appareil d'imagerie optique (20) dans un plan de construction (22) pour la formation successive de couches d'objet solides dans le plan de construction (22), procédé dans lequel des données d'image de couche cible sont fournies pour chaque couche d'objet à solidifier dans le plan de construction (22), où un dispositif (66) pour corriger une distribution d'intensité non homogène d'un champ de rayonnement (13) défini par le rayonnement (14) est prévu et est introduit dans un trajet de rayonnement (70) entre une source de rayonnement (18) générant le rayonnement (14) et le plan de construction (22) et où un champ de rayonnement (13) est généré en fonction des données d'image de couche cibles pour irradier le plan de construction (22), **caractérisé en ce qu'**un système sous forme d'un système selon l'une des revendications 1 à 5 est prévu et **en ce que** le dispositif (66) pour corriger une distribution d'intensité non homogène du rayonnement (14) est introduit dans un trajet de rayonnement (70) entre la source de rayonnement (18) générant le rayonnement (14) et le plan de construction (22).

12. Dispositif (10) pour produire un objet tridimensionnel (12) par solidification par couches d'un matériau (16) solidifiable sous l'action d'un rayonnement (14), avec une source de rayonnement (18) pour générer le rayonnement (14) et un appareil d'imagerie optique (20) pour réaliser une imagerie d'un champ de rayonnement (13) généré par la source de rayonnement (18) dans un plan de construction (22), **caractérisé par** un système selon l'une des revendications 1 à 5.

13. Dispositif selon la revendication 12, **caractérisé en ce que** la source de rayonnement (18) comprend au moins une diode électroluminescente ou au moins une diode laser.

14. Utilisation d'un dispositif (10) pour produire un objet tridimensionnel (12) par solidification par couches d'un matériau (16) solidifiable sous l'action d'un rayonnement (14) selon la revendication 12 ou 13 pour mettre en oeuvre un procédé pour produire un objet tridimensionnel (12) par solidification par couches d'un matériau (16) solidifiable sous l'action d'un rayonnement (14) selon la revendication 11.
